# EUROPEAN PATENT APPLICATION

(11) **EP 4 675 681 A2**
(43) Date of publication of application: **07.01.2026**
(21) Application number: 25172030.6
(22) Date of filing: 23.04.2025
(51) Int. Cl.: H01L 23/482

(54) **POWER SEMICONDUCTOR DEVICES**

(30) Priority: 13.06.2024 KR 20240076820
(71) Applicant: Samsung Electronics Co., Ltd., Suwon-si, Gyeonggi-do 16677 (KR)
(72) Inventor: KIM, Taehun, 16677 Suwon-si (KR); KO, Mingu, 16677 Suwon-si (KR); KIM, Youngcheol, 16677 Suwon-si (KR); KIM, Jongseob, 16677 Suwon-si (KR); PARK, Jeonghwan, 16677 Suwon-si (KR); OH, Sewoong, 16677 Suwon-si (KR)
(74) Representative: Marks & Clerk LLP

(57) **Abstract**

A power semiconductor device may include: a substrate of a first conductivity-type; a drift layer of the first conductivity-type on the substrate; a well region of a second conductivity-type in the drift layer and extending into an upper surface of the drift layer; a source region of the first conductivity-type in the well region and extending into an upper surface of the well region; an insulating liner on the drift layer; a gate structure on the insulating liner; a first gate bus line on the gate structure; a second gate bus line on the first gate bus line, the second gate bus line including a first portion overlapping the first gate bus line and a second portion connected to the first portion; a terminal on the second portion of the second gate bus line; and a drain electrode on a lower surface of the substrate.

## Description

### BACKGROUND

The present disclosure relates to a power semiconductor device, and to a metal-oxide-semiconductor field-effect transistor (MOSFET) power semiconductor device.

Power semiconductor devices may operate in high voltage and high current environments, and may be used in fields that require high power switching, such as power conversion, power converters, inverters, or the like. Power semiconductor devices basically require voltage resistance characteristics against high voltages, and recently, additionally require high-speed switching operations. Accordingly, power semiconductor devices using SiC, which has superior voltage resistance characteristics, as compared to silicon (Si), are being researched.

### SUMMARY

The present disclosure provides a power semiconductor device that may have improved electrical characteristics.

However, aspects of the present are not limited to the above-described aspects, and may be variously expanded without departing from the scope of the present disclosure.

According to an aspect of the disclosure, a power semiconductor device may include: a substrate of a first conductivity-type; a drift layer of the first conductivity-type on the substrate; a well region of a second conductivity-type in the drift layer and extending into an upper surface of the drift layer; a source region of the first conductivity-type in the well region and extending into an upper surface of the well region; an insulating liner on the drift layer; a gate structure on the insulating liner; a first gate bus line on the gate structure; a second gate bus line on the first gate bus line, the second gate bus line including a first portion overlapping the first gate bus line in a direction perpendicular to an upper surface of the substrate, and a second portion connected to the first portion and not overlapping the first gate bus line in the direction perpendicular to the upper surface of the substrate; a terminal on the second portion of the second gate bus line; and a drain electrode on a lower surface of the substrate.

According to an aspect of the disclosure, a power semiconductor device may include: a substrate of a first conductivity-type; a drift layer of the first conductivity-type on the substrate; a well region of a second conductivity-type on the drift layer; a source region of the first conductivity-type on the well region; and a gate structure on the drift layer. The gate structure may include: a first body portion and a second body portion spaced apart in a first direction; and a finger portion connecting the first body portion and the second body portion. The gate structure may include a first gate bus line overlapping the first body portion and the second body portion. The gate structure may include a second gate bus line on the first gate bus line. The second gate bus line may include a first portion overlapping the first gate bus line in a direction perpendicular to an upper surface of the substrate. The second gate bus line may include a second portion connected to the first portion but not overlapping the first gate bus line in the direction perpendicular to the upper surface of the substrate. The power semiconductor device may include a terminal on the second portion of the second gate bus line. The power semiconductor device may include a drain electrode on a lower surface of the substrate.

According to an aspect of the disclosure, a power semiconductor device may include: a substrate of a first conductivity-type. A drift layer of the first conductivity-type may be on the substrate. A well region of a second conductivity-type may be in the drift layer and may extend into an upper surface of the drift layer. A source region of the first conductivity-type may be in the well region and may extend into an upper surface of the well region. An insulating liner may be on the drift layer. A gate structure may be on the insulating liner and may include a cell region and a dummy region. A first gate bus line may overlap the dummy region of the gate structure in a direction perpendicular to an upper surface of the substrate. A second gate bus line may include a first portion overlapping the first gate bus line and may include a second portion connected to the first portion and overlapping the cell region of the gate structure in the direction perpendicular to the upper surface of the substrate. A terminal may be on the second portion of the second gate bus line. A drain electrode may be on a lower surface of the substrate.

At least some of the above and other features of the invention are set out in the claims.

### BRIEF DESCRIPTION OF THE DRAWINGS

The above and other aspects, features, and advantages of the present disclosure will be more clearly understood from the following detailed description, taken in conjunction with the accompanying drawings, in which:
FIG. 1A is a schematic plan view of some components of power semiconductor devices according to one or more embodiments;
FIG. 1B is a schematic plan view of some components of power semiconductor devices according to one or more embodiments;
FIG. 1C is a schematic plan view of some components of power semiconductor devices according to one or more embodiments;
FIG. 2A is a cross-sectional view illustrating one or more embodiments of the power semiconductor device of FIG. 1A, taken along line I-I';
FIG. 2B is a cross-sectional view illustrating one or more embodiments of the power semiconductor device of FIG. 1A, taken along line II-II';
FIG. 3A is a cross-sectional view illustrating one or more embodiments of the power semiconductor device of FIG. 1A, taken along line I-I';
FIG. 3B is a cross-sectional view illustrating one or more embodiments of the power semiconductor device of FIG. 1A, taken along line II-II';
FIG. 4A is a schematic plan view of some components of power semiconductor devices according to one or more embodiments;
FIG. 4B is a schematic plan view of some components of power semiconductor devices according to one or more embodiments;
FIG. 5A is a cross-sectional view illustrating one or more embodiments of the power semiconductor device of FIG. 4A, taken along line III-III';
FIG. 5B is a cross-sectional view illustrating one or more embodiments of the power semiconductor device of FIG. 4A, taken along line IV-IV';
FIG. 6 is a schematic plan view of a component of a power semiconductor device according to one or more embodiments;
FIG. 7 is a cross-sectional view illustrating one or more embodiments of the power semiconductor device of FIG. 6, taken along line V-V';
FIG. 8A is a schematic plan view of some components of a power semiconductor device according to one or more embodiments; and
FIG. 8B is a schematic plan view of some components of a power semiconductor device according to one or more embodiments.

### DETAILED DESCRIPTION

Hereinafter, with reference to the attached drawings, embodiments will be described in more detail. The same reference numerals may be used for the same components in the drawings, and duplicate descriptions of the same components will be omitted.

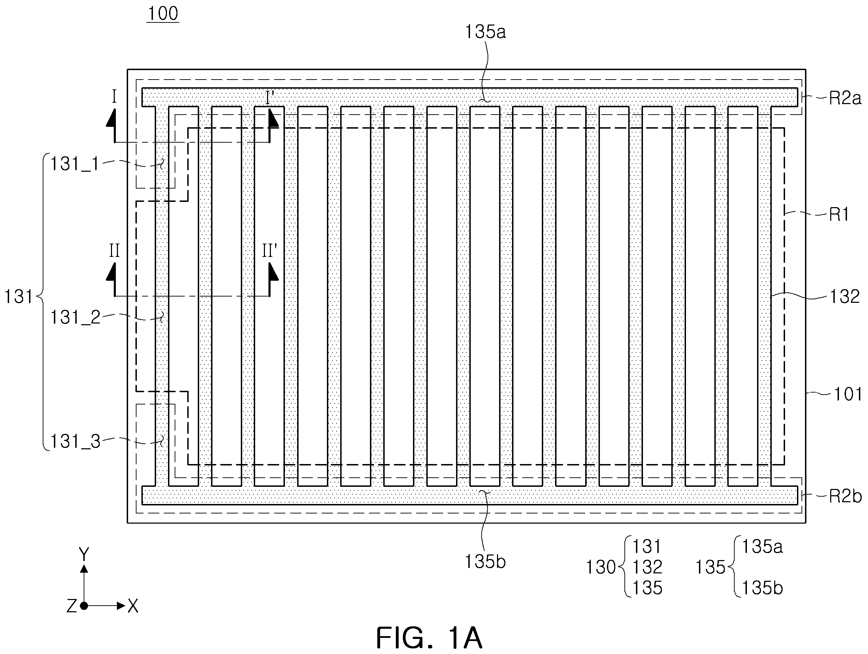

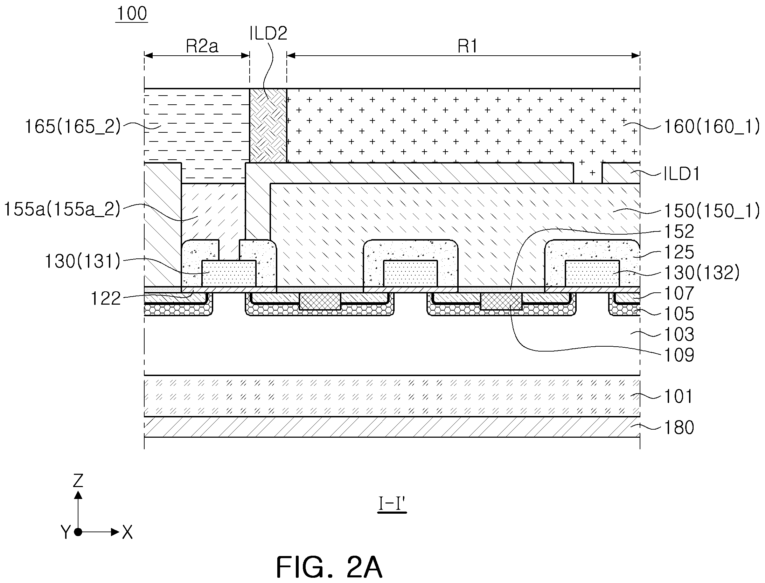

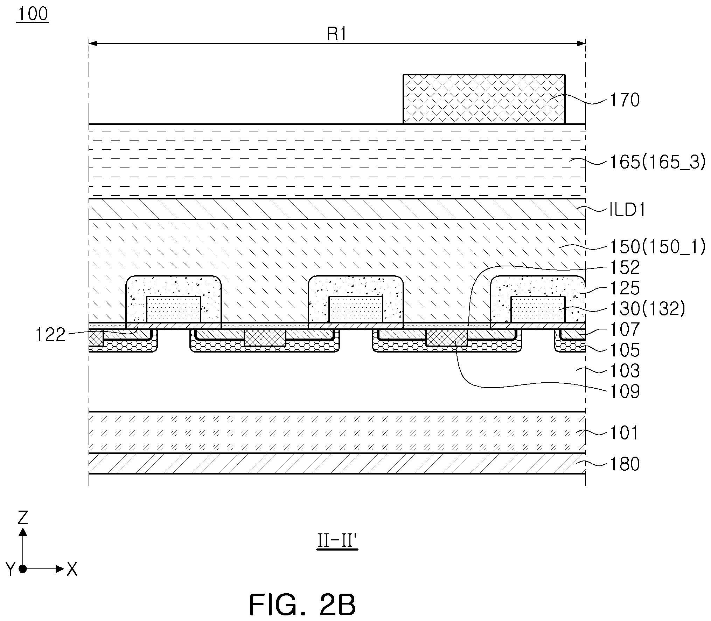

FIGS. 1A to 1C are schematic plan views of some components of power semiconductor devices according to embodiments. FIG. 2A is a cross-sectional view illustrating one or more embodiments of the power semiconductor device of FIG. 1A, taken along line I-I'. FIG. 2B is a cross-sectional view illustrating one or more embodiments of the power semiconductor device of FIG. 1A, taken along line II-II'.

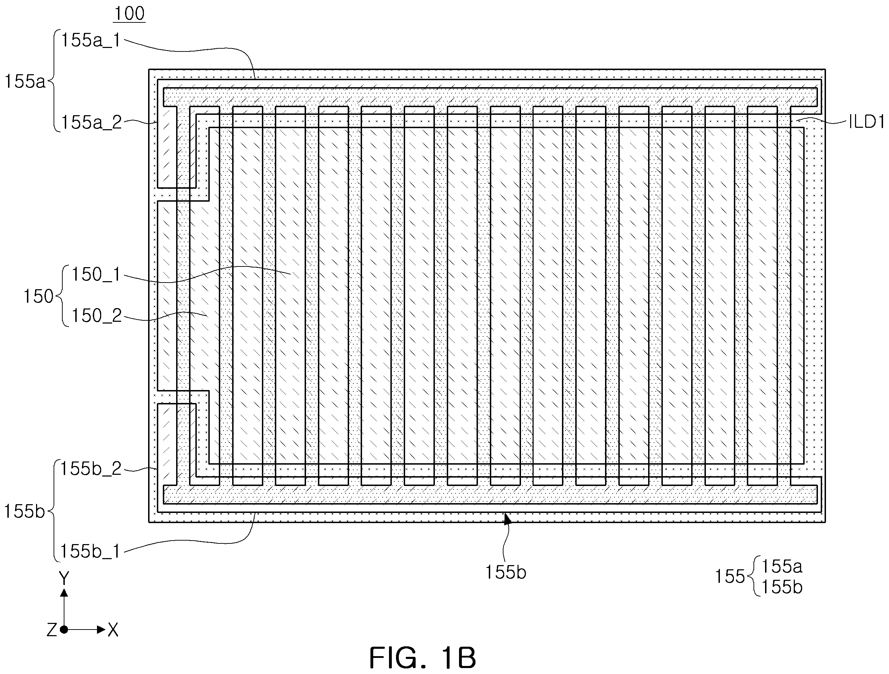

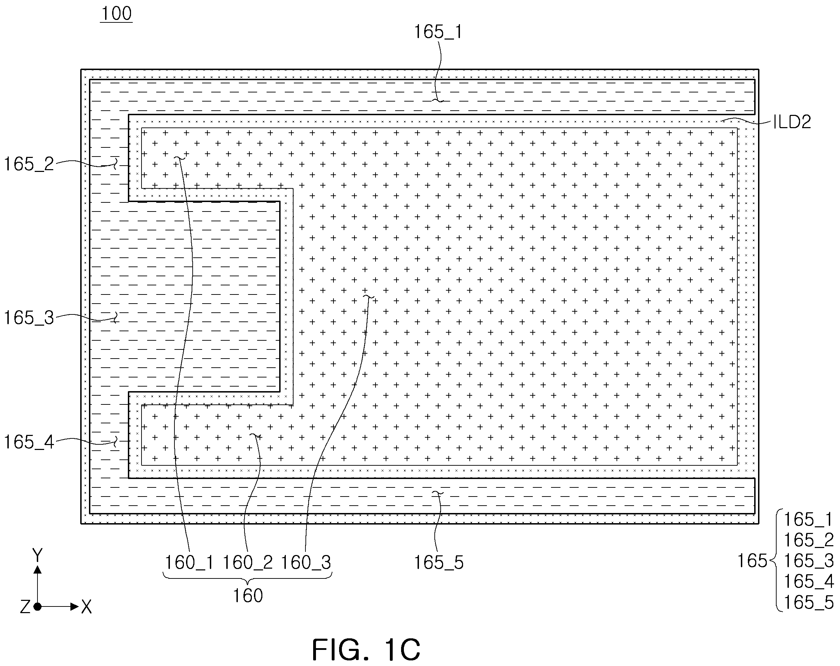

FIG. 1A may be a schematic plan view of a gate structure 130 of a power semiconductor device 100 according to one or more embodiments. FIG. 1B may be a schematic plan view of a first gate bus line 155 and a first source electrode 150 of a power semiconductor device 100 according to one or more embodiments. FIG. 1C may be a schematic plan view of a second gate bus line 165 and a second source electrode 160 of a power semiconductor device 100 according to one or more embodiments.

Referring to FIGS. 1A to 2B, a power semiconductor device 100 may include a substrate 101, a drift layer 103 on the substrate 101, well regions 105 extending from an upper surface of the drift layer 103, a source region 107 extending from an upper surface of a well region 105 in each of the well regions 105, well contact regions 109 on one side of the source region 107, a gate structure 130 on the drift layer 103, an insulating liner 122 between the gate structure 130 and the well region 105, dielectric layers 125 covering the gate structure 130, a first source electrode 150 and a first gate bus line 155, covering the dielectric layers 125, a second source electrode 160 disposed on a portion of the first source electrode 150, a second gate bus line 165 disposed on the first gate bus line 155 and extending onto the first source electrode 150, and a drain electrode 180 on a lower surface of the substrate 101. In an example, the power semiconductor device 100 may further include a first insulating pattern ILD1 disposed between the first source electrode 150 and the first gate bus line 155, and a second insulating pattern ILD2 disposed between the second source electrode 160 and the second gate bus line 165.

The substrate 101 may have an upper surface extending in a first direction (X-direction) and a second direction (Y-direction). The substrate 101 may include a semiconductor material, for example, SiC. In one or more embodiments, the substrate 101 may include a group IV semiconductor material such as Si or Ge, or a compound semiconductor material such as GaN, SiGe, GaAs, InAs, or InP.

The substrate 101 may be provided as a bulk wafer or an epitaxial layer. The substrate 101 may include impurities of a first conductivity-type, and thus may have the first conductivity-type. In one or more embodiments, the first conductivity-type may be, for example, an N-type, and impurities of the first conductivity-type may be, for example, impurities of the N-type, such as nitrogen (N) and/or phosphorus (P). In one or more embodiments, the first conductivity-type may be, for example, a P-type, and the first conductivity-type impurities may be, for example, impurities of the P-type, such as aluminum (Al). Hereinafter, unless otherwise specified, the description will be based on a case in which the power semiconductor device 100 includes an N-type MOSFET. The power semiconductor device 100 may include a P-type MOSFET as the first conductivity-type.

The drift layer 103 may be disposed on the substrate 101. The drift layer 103 may include a semiconductor material. The drift layer 103 may be an epitaxial layer grown on the substrate 101. The drift layer 103 may include the impurities of the first conductivity-type, and thus may have the first conductivity-type. A concentration of the impurities of the first conductivity-type in the drift layer 103 may be lower than a concentration of the impurities of the first conductivity-type in the substrate 101. In embodiments, the impurities of the first conductivity-type in the substrate 101 may be equal to or different from the impurities of the first conductivity-type in the drift layer 103.

The well regions 105 may be disposed at a predetermined depth from the upper surface of the drift layer 103, and may be disposed spaced apart from each other in a horizontal direction, for example, the first direction (X-direction). The well region 105 may include a semiconductor material, for example, SiC. The well region 105 may be a region having a second conductivity-type, and may include impurities of the second conductivity-type. The second conductivity-type may be, for example, a P-type, and the impurities of the second conductivity-type may be, for example, impurities of the P-type such as aluminum (Al). In one or more embodiments, the well region 105 may include a plurality of regions having different doping concentrations.

The source regions 107 may be disposed in each of the well regions 105, and may be disposed at a predetermined depth from the upper surface of the well region 105. A thickness of the source region 107 may be smaller than a thickness of the well region 105. The source region 107 may include a semiconductor material, for example, SiC. A concentration of the impurities of the first conductivity-type in the source region 107 may be higher than a concentration of the impurities of the first conductivity-type in the drift layer 103, but is not limited thereto.

The well contact regions 109 may be disposed on the well regions 105 on one side, together with at least a portion of the source regions 107. The well contact region 109 may be disposed between the well region 105 and the first source electrode 150 to allow a voltage to be applied to the well region 105 from the first source electrode 150. **In** an example, a relative depth of the well contact region 109 and a relative depth of the source region 107 may be changed. The well contact region 109 may include a semiconductor material, for example, SiC. The well contact region 109 may be a region having the second conductivity-type, and may include the impurities of the second conductivity-type described above. A concentration of the impurities of the second conductivity-type in the well contact region 109 may be higher than a concentration of the impurities of the second conductivity-type in the well region 105.

The gate structure 130 may be disposed on the insulating liner 122 of the drift layer 103, and may be disposed on one end portions of the source regions 107 and the well regions 105 outside the source regions 107. The gate structure 130 may be disposed to overlap a portion of the source region 107 and a portion of the well region 105 in the third direction (Z-direction). The gate structure 130 may be separated from the source region 107, the well region 105, and the drift layer 103 by the insulating liner 122.

The gate structure 130 may include body portions 135 extending in the first direction (X-direction), and finger portions 131 and 132 disposed between the body portions 135 and connecting the body portions 135.

The body portions 135 may include first and second body portions 135a and 135b extending in the first direction (X-direction) and spaced apart in the second direction (Y-direction). The finger portions 131 and 132 may be a plurality of gate electrodes extending from the first and second body portions 135a and 135b in the second direction (Y-direction) and spaced apart from each other in the first direction (X-direction). The fingers 131 and 132 may include a first finger 131 overlapping a portion of the first gate bus line 155, described later, in the third direction (Z-direction), and a second finger 132 overlapping the first source electrode 150 in the third direction (Z-direction). The first finger 131 may be a gate electrode disposed at an outermost side between the first and second body portions 135a and 135b and extending in the second direction (Y-direction). In an example, the first finger 131 is illustrated as one gate electrode disposed between the first body portion 135a and the second body portion 135b, but is not limited thereto, and may include two or more gate electrodes. The second finger portion 132 may be illustrated as having 14 gate electrodes disposed between the first body portion 135a and the second body portion 135b, but is not limited thereto, and may include more than 14 or less than 14 gate electrodes.

The first finger portion 131 may include first electrode portions 131_1 and 131_3 overlapping the first gate bus line 155, and a second electrode portion 131_2 disposed between the first electrode portions 131_1 and 131_3 and overlapping the first source electrode 150. In an example, the first electrode portions 131_1 and 131_3 of the first finger portion 131 may include a 1-1 electrode portion 131_1 which may be one end portion of the first finger portion 131 extending from the first body portion 135a, and a 1-2 electrode portion 131_3 which may be the other end portion of the first finger portion 131 extending from the second body portion 135b. In this document, the first finger portion 131 may be referred to as a first gate electrode.

The gate structure 130 may include a cell region R1 and a dummy region (R2a and R2b). In an example, the cell region R1 of the gate structure 130 may be a region overlapping the first source electrode 150, described later, in the third direction (Z-direction). The dummy region (R2a and R2b) of the gate structure 130 may be a region overlapping the first gate bus line 155, described later, in the third direction (Z-direction). In other words, the gate structure 130 may have a dummy portion in the dummy region R2a/R2b.

The cell region R1 of the gate structure 130 may include the second electrode portion 131_2 of the first finger portion 131 and the second finger portion 132. The dummy region (R2a and R2b) of the gate structure 130 may include the first and second body portions 135a and 135b and the first electrode portions 131_1 and 131_3 of the first finger portion 131.

The gate structure 130 may include a conductive material, and may include, for example, a semiconductor material such as doped polycrystalline silicon, a metal nitride such as titanium nitride (TiN), tantalum nitride (TaN), or tungsten nitride (WN), and/or a metal material such as aluminum (Al), tungsten (W), molybdenum (Mo), or the like. According to one or more embodiments, the gate structure 130 may be formed as two or more multilayer structures.

The insulating liner 122 may be disposed on a lower surface of the gate structure 130. The insulating liner 122 may extend onto the source region 107, the well region 105 outside the source region 107, and the drift layer 103. The insulating liner 122 may be disposed between the source region 107, the well region 105, the drift layer 103, and the gate structure 130. The insulating liner 122 may function as a gate insulating layer of the gate structure 130.

The insulating liner 122 may include an insulating material. For example, the insulating liner 122 may include an oxide, a nitride, or a high-κ material. The high-κ material may mean a dielectric material having a higher dielectric constant than a dielectric constant of silicon oxide (SiO₂). The high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃).

The dielectric layers 125 may cover the gate structure 130 and a portion of the insulating liner 122, and may be disposed to expose a portion of each of the source regions 107. The dielectric layers 125 may cover side and upper surfaces of the gate structure 130. The dielectric layer 125 may include an insulating material, and may include at least one of silicon oxide, silicon nitride, or silicon oxynitride.

The first gate bus line 155 and the first source electrode 150 may be disposed on the gate structure 130. In an example, the first gate bus line 155 may be disposed on the first and second body portions 135a and 135b of the gate structure 130 and the first electrode portions 131_1 and 131_3 of the first finger portion 131 extending from the first and second body portions 135a and 135b of the gate structure 130. The first source electrode 150 may be disposed on the second finger portion 132 of the gate structure 130 and the second electrode portion 131_2 of the first finger portion 131.

The first gate bus line 155 may be in contact with a dielectric layer 125 covering first and second body portions 135a and 135b of the gate structure 130 and a portion of the first finger portion 131. In an example, the first gate bus line 155 may include two gate bus lines. In an example, the first gate bus line 155 may include a 1-1 gate bus line 155a overlapping the first body portion 135a, and a 1-2 gate bus line 155b overlapping the second body portion 135b. In an example, the 1-1 gate bus line 155a and the 1-2 gate bus line 155b may be spaced apart from each other in the second direction (Y-direction). The 1-1 gate bus line 155a and the 1-2 gate bus line 155b may be symmetrical in the second direction (Y-direction) with respect to the first source electrode 150.

The 1-1 gate bus line 155a may include a 1-1 extension portion 155a_1 overlapping the first body portion 135a and extending in the first direction (X-direction), and a 1-1 bent portion 155a_2 extending from the 1-1 extension portion 155a_1 (e.g., extending in the second direction (Y direction)) and disposed on one end (e.g., the 1-1 electrode portion 131_1) of the first finger portion 131. In an example, the 1-2 gate bus line 155b may include a 1-2 extension portion 155b_1 overlapping the second body portion 135b and extending in the first direction (X-direction), and a 1-2 bent portion 155b_2 extending from the 1-2 extension portion 155b_1 (e.g., extending in the second direction (Y direction)) and disposed on the other end (e.g., the 1-2 electrode portion 131_3) of the first finger portion 131. In an example, the 1-1 extension portion 155a_1 and the 1-2 extension portion 155b_1 may be referred to as a third portion in this document, and the 1-1 bent portion 155a_2 and the 1-2 bent portion 155b_2 may be referred to as a fourth portion.

The first gate bus line 155 may pass through the dielectric layer 125 in at least one region to be connected to the gate structure 130. In an example, the first gate bus line 155 may pass through the dielectric layer 125 covering the first finger portion 131 to be connected to the gate structure 130. For example, the 1-1 gate bus line 155a and the 1-2 gate bus line 155b may pass through the dielectric layer 125 covering one end of the first finger portion 131 and the other end of the first finger portion 131, respectively, to be connected to the gate structure 130 (or, the first finger portion 131).

The first source electrode 150 may be disposed on a portion of the gate structure 130. In an example, the first source electrode 150 may be disposed on the dielectric layer 125 covering the second electrode portion 131_2 of the first finger portion 131 and the second finger portion 132. The first source electrode 150 may include a 1-1 source electrode 150_1 disposed on the second finger portion 132, and a 1-2 source electrode 150_2 extending from the 1-1 source electrode 150_1 and disposed on the second electrode portion 131_2 of the first finger portion 131.

A metal-semiconductor compound layer 152 may be disposed at an interface on which the first source electrode 150 and the source region 107 are in contact. The metal-semiconductor compound layer 152 may include a metal element and a semiconductor element, and may include, for example, at least one of TiSi, CoSi, MoSi, LaSi, NiSi, TaSi, or WSi.

An upper portion surface of the first gate bus line 155 may be disposed on a level, substantially equal to a level of an upper portion surface of the first source electrode 150.

In some embodiments, the first gate bus line 155 may not overlap the first source electrode 150 in the vertical direction (Z-direction), and the first source electrode 150 may be disposed between the 1-1 and 1-2 gate bus lines 155a and 155b. The first insulating pattern ILD1 may be disposed between the first gate bus line 155 and the first source electrode 150. The first gate bus line 155 may not be electrically connected to the first source electrode 150 by the first insulating pattern ILD1.

The first insulating pattern ILD1 may cover an upper surface of the first gate bus line 155 and an upper surface of the first source electrode 150, and may fill a space between the first gate bus line 155 and the first source electrode 150. An upper portion surface of the first insulating pattern ILD1 may be disposed on a level, higher than a level of the upper portion surface of the first gate bus line 155 and a level of the upper portion surface of the first source electrode 150.

The second source electrode 160 and the second gate bus line 165 may be disposed on the first source electrode 150 and the first gate bus line 155. In an example, the second source electrode 160 and the second gate bus line 165 may be disposed on the first insulating pattern ILD1 disposed on the first source electrode 150 and the first gate bus line 155. The second source electrode 160 and the second gate bus line 165 may be in contact with the first insulating pattern ILD1 covering the upper surface of the first source electrode 150 and the upper surface of the first gate bus line 155.

The second gate bus line 165 may include a first portion (165_1, 165_2, 165_4, and 165_5) overlapping the first gate bus line 155, and a second portion 165_3 extending from the first portion (165_1, 165_2, 165_4, and 165_5) to connect the first portion (165_1, 165_2, 165_4, and 165_5). In an example, the second gate bus line 165 may be an integral electrode structure. For example, the first portion (165_1, 165_2, 165_4, and 165_5) and the second portion 165_3 may be formed as one electrode structure. In an example, the first portion (165_1, 165_2, 165_4, and 165_5) may include a 1-1 portion (165_1 and 165_2) overlapping the 1-1 gate bus line 155a of the first gate bus line 155, and a 1-2 portion (165_4 and 165_5) overlapping the 1-2 gate bus line 155b. In an example, the second portion 165_3 may overlap the first source electrode 150. In an example, the second portion 165_3 may not overlap the first gate bus line 155 in the vertical direction (Z direction). In an example, the first portion (165_1, 165_2, 165_4, and 165_5) of the second gate bus line 165 may overlap the first and second body portions 135a and 135b and a portion of the first finger portion 131 of the gate structure 130 in the vertical direction (Z-direction). In an example, the first portion (165_1, 165_2, 165_4, and 165_5) of the second gate bus line 165 may overlap the dummy region (R2a and R2b) of the gate structure 130.

The second gate bus line 165 may pass through the first insulating pattern ILD1 in at least one region to be vertically connected to the first gate bus line 155. In an example, the second gate bus line 165 may pass through the first insulating pattern ILD1 in the 1-1 portion (165_1 and 165_2) to be connected to the 1-1 gate bus line 155a. For example, the second gate bus line 165 may pass through the first insulating pattern ILD1 disposed below the 1-1 portion (165_2), to be connected to the 1-1 gate bus line 155a. In an example, the second gate bus line 165 may pass through the first insulating pattern ILD1 in the 1-2 portion (165_4 and 165_5), to be connected to the 1-2 gate bus line 155b. For example, the second gate bus line 165 may pass through the first insulating pattern ILD1 disposed below the 1-2 portion (165_4), to be connected to the 1-2 gate bus line 155b.

The second portion 165_3 of the second gate bus line 165 may extend from the first portion (165_1, 165_2, 165_4, and 165_5), and may overlap the first source electrode 150 in the vertical direction (Z-direction). The second portion 165_3 of the second gate bus line 165 may be a region in which a conductive terminal 170, described later, is disposed, and may be a gate pad region for the gate structure 130. In an example, the second portion 165_3 of the second gate bus line 165 may overlap the second electrode portion 131_2 of the first finger portion 131 of the gate structure 130 and a portion of the second finger portion 132 adjacent to the first finger portion 131 in the vertical direction (Z-direction). The second portion 165_3 of the second gate bus line 165 may overlap the cell region R1 of the gate structure 130.

The conductive terminal 170 and the first and second gate bus lines 155 and 165 may be electrically connected to the gate structure 130, and may be gate interconnection structures for connecting the gate structure 130 externally. The conductive terminal 170 may be disposed on the second portion 165_3 of the second gate bus line 165. In an example, the second portion 165_3 of the second gate bus line 165 may overlap the conductive terminal 170 in the vertical direction (Z-direction). In an example, the conductive terminal 170 may not overlap the first gate bus line 155 in the third direction (Z direction). In an example, the conductive terminal 170 may overlap at least a portion of the fingers 131 and 132 of the gate structure 130 in the third direction (Z-direction). The conductive terminal 170 may have an upper surface on which a pad metal layer or a wire structure is arranged and may be electrically connected to the pad metal layer or the wire structure to receive an electrical signal. In another example, the conductive terminal 170 may be a gate wire or a wire pad to which the gate wire is connected. In an example, the second portion 165_3 of the second gate bus line 165 may extend to reach a lower portion of the conductive terminal 170, and may be electrically connected thereto. The conductive terminal 170 may have a shape such as a tetragon, a circle, an ellipse, or the like in a plan view.

The second source electrode 160 may be disposed on the first insulating pattern ILD1 covering the first source electrode 150. The second source electrode 160 may overlap the first source electrode 150 in the vertical direction (Z-direction). In an example, an area of the second source electrode 160 on a plane may be smaller than an area of the first source electrode 150 on a plane.

The second source electrode 160 may pass through the first insulating pattern ILD1 in at least one region thereof, to be vertically connected to the first source electrode 150.

The second source electrode 160 may include a 2-1 source electrode 160_3 and 2-2 source electrodes 160_1 and 160_2 extending from the 2-1 source electrode 160_3 and disposed between the first portion (165_1 and 165_5) and the second portion 165_3 of the second gate bus line 165. The 2-2 source electrodes 160_1 and 160_2 may include a 2-2a source electrode 160_1 located between the first portion 165_1 and the second portion 165_3, and a 2-2b source electrode 160_2 located between the first portion 165_5 and the second portion 165_3. The 2-2a source electrode 160_1 and the 2-2b source electrode 160_2 may be spaced apart in the second direction (Y-direction) with the second portion 165_3 of the second gate bus line 165 therebetween.

The second gate bus line 165 may not overlap the second source electrode 160 in the vertical direction (Z-direction), and may be located side by side in a horizontal direction. The second insulating pattern ILD2 may be disposed between the second gate bus line 165 and the second source electrode 160. The second gate bus line 165 may not be electrically connected to the second source electrode 160 by the second insulating pattern ILD2.

The second insulating pattern ILD2 may fill a space between the second gate bus line 165 and the second source electrode 160. An upper portion surface of the second insulating pattern ILD2 may be disposed on a level, equal to a level of the upper portion surface of the second gate bus line 165 and a level of the upper portion surface of the second source electrode 160.

The first and second source electrodes 150 and 160 may include at least one of a metal material, for example, nickel (Ni), aluminum (Al), titanium (Ti), silver (Ag), vanadium (V), tungsten (W), cobalt (Co), molybdenum (Mo), copper (Cu), or ruthenium (Ru).

The first and second gate bus lines 155 and 165 may include a conductive material. For example, the first and second gate bus lines 155 and 165 may include a metal material. For example, the first and second gate bus lines 155 and 165 may include at least one of titanium nitride (TiN), titanium (Ti), titanium carbide (TiC), tantalum nitride (TaN), tungsten nitride (WN), aluminum (Al), tungsten (W), or molybdenum (Mo).

The drain electrode 180 may be disposed on the lower surface of the substrate 101, and may be electrically connected to the substrate 101. The drain electrode 180 may include a metal material, for example, at least one of nickel (Ni), aluminum (Al), titanium (Ti), silver (Ag), vanadium (V), or tungsten (W). In one or more embodiments, the drain electrode 180 may also include a metal-semiconductor compound layer, similar to the metal-semiconductor compound layer 152.

A power semiconductor device according to embodiments may include a first gate bus line 155 connected to a gate structure 130 (gate electrode), and a second gate bus line 165 connected to the first gate bus line 155 and a conductive terminal 170 and overlapping a first source electrode 150 (or a cell region R1). Therefore, a power semiconductor device having improved electrical characteristics may be provided by securing the cell region R1.

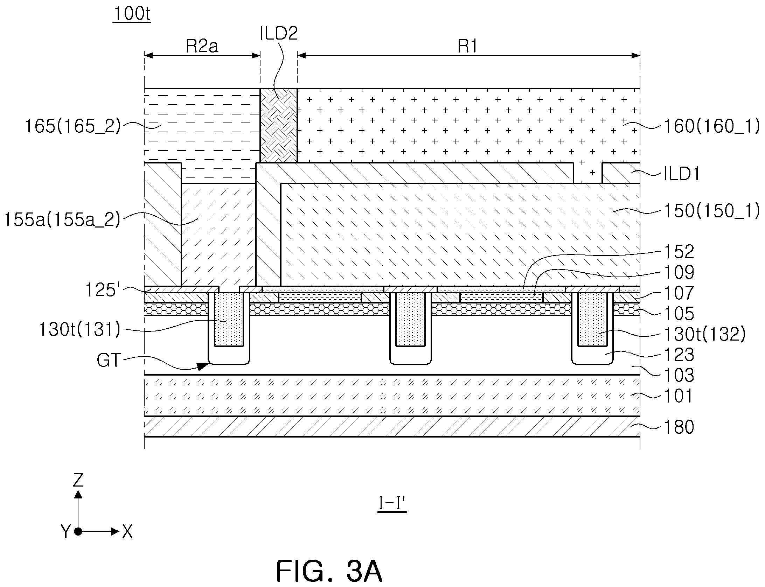

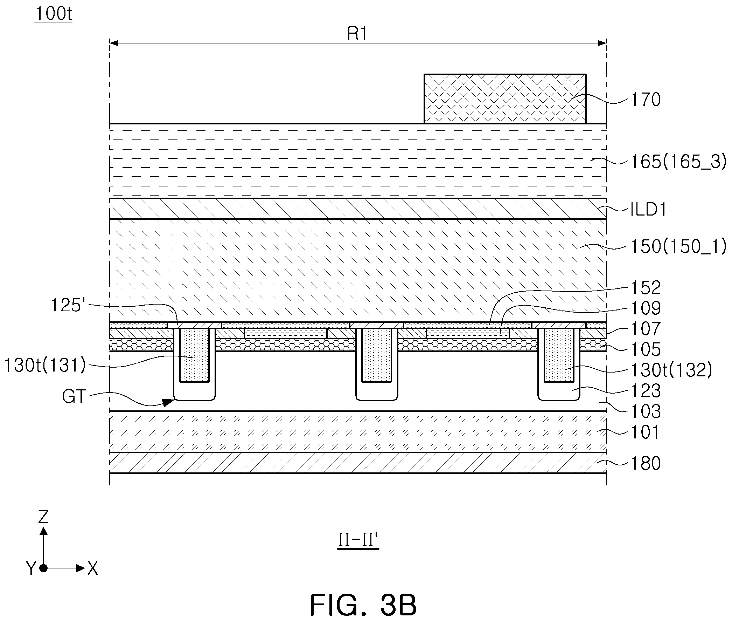

FIG. 3A is a cross-sectional view illustrating one or more embodiments of the power semiconductor device of FIG. 1A, taken along line I-I'. FIG. 3B is a cross-sectional view illustrating one or more embodiments of the power semiconductor device of FIG. 1A, taken along line II-II'.

Referring to FIGS. 3A and 3B, a power semiconductor device 100t may be equal to or correspond to configurations illustrated in FIGS. 2A and 2B, except for a gate structure 130t in a gate trench GT, a gate insulating film 123, and well contact regions 109. For remaining configurations except for the gate structure 130t in the gate trench GT, the gate insulating film 123, and the well contact regions 109, overlapping descriptions of components, equal to or corresponding to the configurations illustrated in FIGS. 2A and 2B, will be omitted.

The well contact regions 109 may be disposed on well regions 105 between source regions 107 adjacent to each other. The well contact regions 109 may be disposed between the well region 105 and the source regions 107 such that voltage is applied to the well region 105 from first and second source electrodes 150 and 160. The well contact regions 109 may include a semiconductor material, and may include, for example, SiC. The well contact region 109 may be a region having a second conductivity-type, and may include impurities of the second conductivity-type, as described above. A concentration of the impurities of the second conductivity-type in the well contact region 109 may be higher than a concentration of the impurities of the second conductivity-type in the well region 105.

The gate trench GT may extend from upper surfaces of the source regions 107 through the source regions 107 and the well regions 105 into a drift layer 103. The gate trench GT may completely pass through the well region 105, and a lower end of the gate trench GT may be located in the drift layer 103. A length by which the gate trench GT extends into the drift layer 103 may be changed according to various embodiments. In an example, the lower end of the gate trench GT may be located on an upper surface of the drift layer 103.

The gate trench GT may include a sidewall extending in the third direction (Z-direction) and contacting the source regions 107, the well regions 105, and the drift layer 103, and a bottom surface extending from the sidewall and contacting the drift layer 103. In another example, the gate trench GT may include a sidewall contacting the source regions 107 and the well regions 105, and a bottom surface extending from the sidewall and contacting the well region 105.

The gate trench GT may have an angular shape without a curve. An angle between the sidewall and the bottom surface of the gate trench GT may be a right angle. In an example, the sidewall of the gate trench GT may have a side surface extending vertically, and a width of the gate trench GT may be substantially constant. The present disclosure is not limited thereto. In another example, the angle between the sidewall and the bottom surface of the gate trench GT may be an obtuse angle. In this case, the sidewall of the gate trench GT may have an inclined side surface. The width of the gate trench GT may decrease toward a lower portion of the gate trench GT. In an example, the bottom surface of the gate trench GT may substantially extend in a straight line in the first direction (X-direction), but is not limited thereto, and a shape of the gate trench GT may be variously modified.

The gate structure 130t may be respectively disposed in the gate trench GT. The gate structure 130t may be disposed on the gate insulating film 123 in the gate trench GT. In an example, the gate structure 130t may overlap the gate insulating film 123, the drift layer 103, the well region 105, and the source region 107 in a horizontal direction. A lower surface of the gate structure 130t may be located in the drift layer 103. The lower surface of the gate structure 130t may be located on a level, lower than a level of a lower surface of the well region 105, and an upper surface of the gate structure 130t may be disposed on a level, equal to a level of an upper surface of the source region 107, but is not limited thereto, and the upper surface of the gate structure 130t may be located on a level, lower than a level of the upper surface of the source region 107.

The gate structure 130t may include the side surface having a shape corresponding to the sidewall of the gate trench GT, an upper portion surface extending from the side surface and contacting a dielectric layer 125', and a lower portion surface contacting the gate insulating film 123. In an example, the side surface of the gate structure 130t may be perpendicular to a substrate 101, but is not limited thereto. The side surface of the gate structure 130t may have an inclined side surface with respect to the substrate 101.

The gate insulating film 123 may be disposed in the gate trench GT. The gate insulating film 123 may cover the side surface and the bottom surface of the gate structure 130t. In an example, the gate insulating film 123 may be disposed between the source region 107, the well contact region 109, the well region 105, and the drift layer 103, and the gate structure 130t. The gate insulating film 123 may include an insulating material. The insulating material may include an oxide or a nitride. The gate insulating film 123 may be formed as a plurality of insulating layer films.

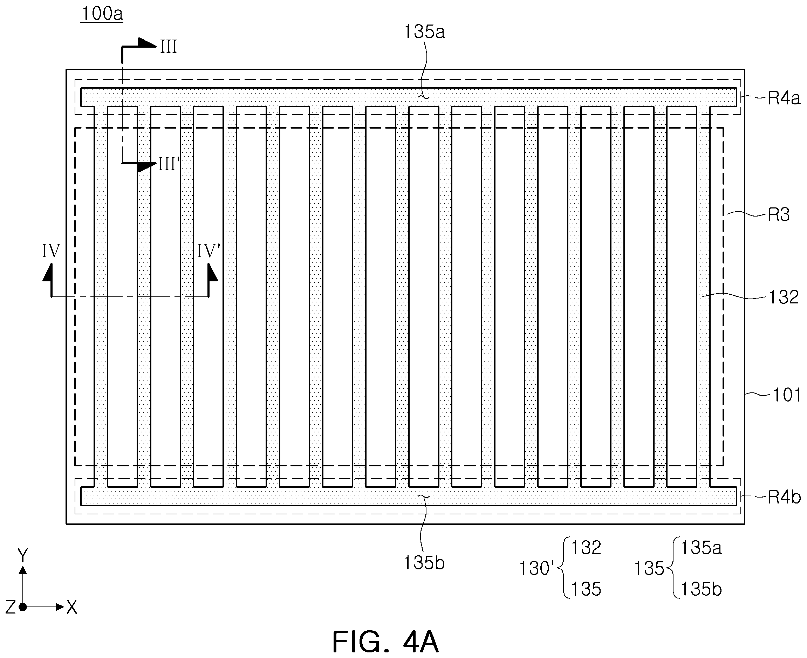

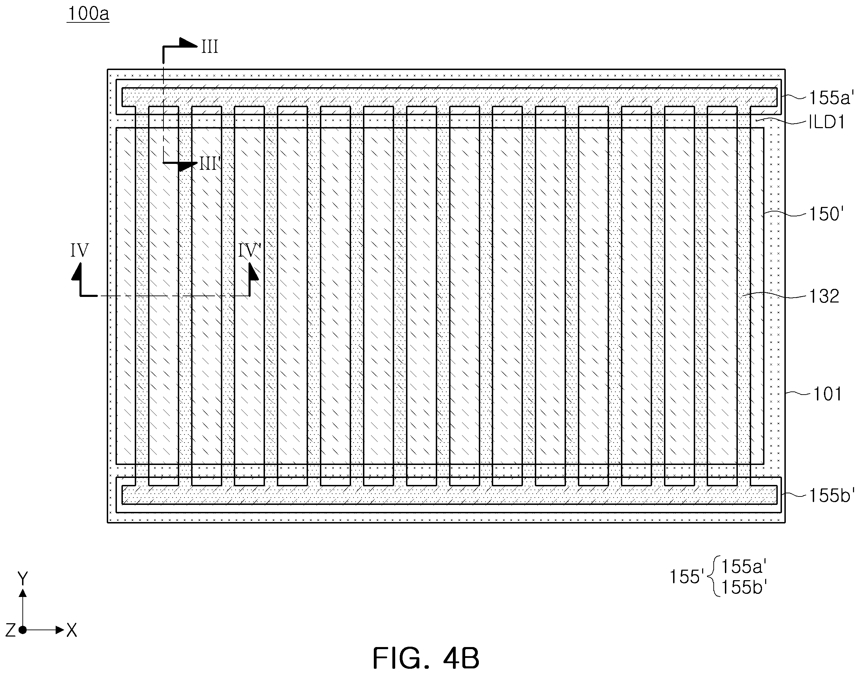

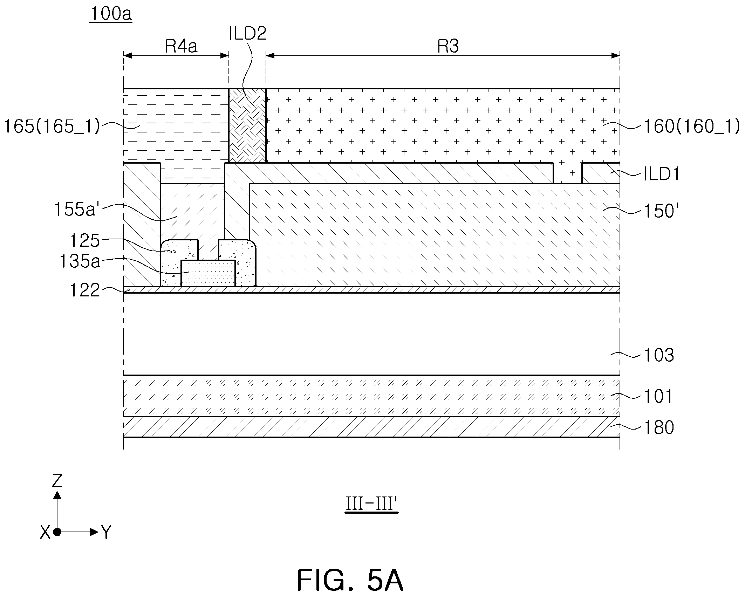

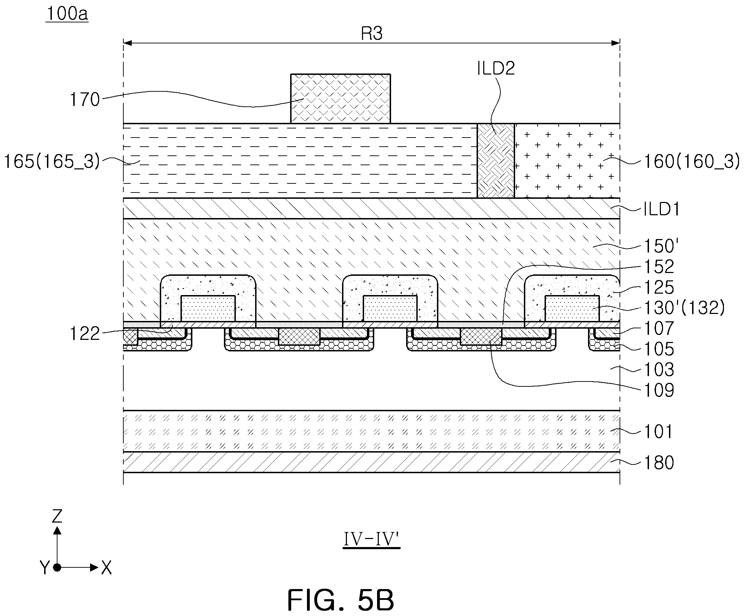

FIGS. 4A and 4B are schematic plan views of some components of power semiconductor devices according to one or more embodiments. FIG. 5A is a cross-sectional view illustrating one or more embodiments of the power semiconductor device of FIG. 4A, taken along line III-III". FIG. 5B is a cross-sectional view illustrating one or more embodiments of the power semiconductor device of FIG. 4A, taken along line IV-IV'.

FIG. 4A may be a schematic plan view of a gate structure 130' of a power semiconductor device 100a according to one or more embodiments. FIG. 4B may be a schematic plan view of a first gate bus line 155' and a first source electrode 150' of a power semiconductor device 100a according to one or more embodiments. The second gate bus line 165 and the second source electrode 160 of the power semiconductor device 100 of FIG. 1C may be equally applied to the power semiconductor device 100a.

Referring to FIGS. 4A to 5B, a power semiconductor device 100a may be equal to or correspond to configurations illustrated in FIGS. 2A and 2B, except for a gate structure 130', a first gate bus line 155', and a first source electrode 150'. Overlapping descriptions of components, equal to or corresponding to the configurations illustrated in FIGS. 2A and 2B, will be omitted.

Referring to FIGS. 4A to 5B, the power semiconductor device 100a may include a substrate 101, a drift layer 103 on the substrate 101, well regions 105 extending from an upper surface of the drift layer 103, a source region 107 extending from an upper surface of a well region 105 in each of the well regions 105, a gate structure 130' on the drift layer 103, an insulating liner 122 between the gate structure 130' and the well region 105, dielectric layers 125 covering the gate structure 130', a first source electrode 150' and a first gate bus line 155' covering the dielectric layers 125, a second source electrode 160 disposed on a portion of the first source electrode 150', a second gate bus line 165 disposed on the first gate bus line 155' and extending onto the first source electrode 150', and a drain electrode 180 on a lower surface of the substrate 101. In an example, the power semiconductor device 100a may further include a first insulating pattern ILD1 disposed between the first source electrode 150' and the first gate bus line 155', and a second insulating pattern ILD2 disposed between the second source electrode 160 and the second gate bus line 165.

The gate structure 130' may include body portions 135 extending in the first direction (X-direction), and a finger portion 132 disposed between the body portions 135 and connecting the body portions 135.

The body portions 135 may include first and second body portions 135a and 135b extending in the first direction (X-direction) and spaced apart in the second direction (Y-direction). The finger portion 132 may be provided as a plurality of gate electrodes extending from the first and second body portions 135a and 135b in the second direction (Y-direction) and spaced apart from each other in the first direction (X-direction).

The gate structure 130' may include a cell region R3 and dummy regions R4a and R4b. In an example, the cell region R3 of the gate structure 130' may be a region overlapping the first source electrode 150', described later, in the third direction (Z-direction). A dummy region R4a and R4b of the gate structure 130' may be a region overlapping the first gate bus line 155', described later, in the third direction (Z-direction).

The first gate bus line 155' and the first source electrode 150' may be disposed on the gate structure 130'. In an example, the first gate bus line 155' may be disposed on the body portion 135 of the gate structure 130'. The first gate bus line 155' may be in contact with a dielectric layer 125 covering the body portion 135 of the gate structure 130'.

The first gate bus line 155' may include a 1-1 gate bus line 155a' overlapping the first body portion 135a, and a 1-2 gate bus line 155b' overlapping the second body portion 135b. In an example, the 1-1 and 1-2 gate bus lines 155a' and 155b' may be spaced apart from each other in the second direction (Y-direction), and may have a bar shape extending in the first direction (X-direction). For example, the dummy regions R4a and R4b of the gate structure 130' may have a bar shape corresponding to the 1-1 gate bus line 155a' and 1-2 gate bus line 155b'.

The first gate bus line 155' may pass through the dielectric layer 125 covering the first and second body portions 135a and 135b, to be connected to the gate structure 130'. In an example, the 1-1 gate bus line 155a' may pass through the dielectric layer 125 covering the first body portion 135a, to be connected to the gate structure 130'. For example, the 1-2 gate bus line 155b' may pass through the dielectric layer 125 covering the second body portion 135b, to be connected to the gate structure 130'.

The first source electrode 150' may overlap the finger portion 132 of the gate structure 130' in the vertical direction (Z-direction). For example, the cell region R3 of the gate structure 130' may have a tetragonal shape corresponding to a shape of the first source electrode 150'.

An upper portion surface of the first gate bus line 155' may be disposed on a level, substantially equal to a level of an upper portion surface of the first source electrode 150'.

The first gate bus line 155' may not overlap the first source electrode 150' in the third direction (Z-direction) and the first direction (X-direction). The 1-1 gate bus line 155a' and the 1-2 gate bus line 155b' may be spaced apart in the second direction (Y-direction) with the first source electrode 150' interposed therebetween. In an example, the 1-1 gate bus line 155a', the first source electrode 150', and the 1-2 gate bus line 155b' may be disposed to be sequentially spaced apart in the second direction (Y-direction). In an example, the first insulating pattern ILD1 may be disposed in a space between the first gate bus line 155' and the first source electrode 150' and on the first gate bus line 155' and the first source electrode 150'.

The second source electrode 160 and the second gate bus line 165 may be disposed on the first source electrode 150' and the first gate bus line 155'. In an example, the second source electrode 160 and the second gate bus line 165 may be disposed on the first insulating pattern ILD1 disposed on the first source electrode 150' and the first gate bus line 155'. The second source electrode 160 and the second gate bus line 165 may be in contact with the first insulating pattern ILD1 covering an upper surface of the first source electrode 150' and an upper surface of the first gate bus line 155'.

The second gate bus line 165 may include a first portion (165_1 and 165_5) overlapping the first gate bus line 155', and a second portion (165_2, 165_3, and 165_4) extending from the first portion (165_1 and 165_5) and connecting the first portions (165_1 and 165_5). The first portion (165_1 and 165_5) of the second gate bus line 165 may include a 1-1 portion 165_1 overlapping the 1-1 gate bus line 155a', and a 1-2 portion 165_5 overlapping the 1-2 gate bus line 155b'. In an example, the second portions (165_2, 165_3, and 165_4) may overlap the first source electrode 150'. In an example, the first portions (165_1 and 165_5) may overlap the first and second body portions 135a and 135b of the gate structure 130'. The second portions (165_2, 165_3, and 165_4) may overlap the finger portions 132 of the gate structure 130'. In an example, the first portion (165_1 and 165_5) of the second gate bus line 165 may overlap the dummy region (R4a and R4b) of the gate structure 130'. The second portion (165_2, 165_3, and 165_4) of the second gate bus line 165 may overlap the cell region R3 of the gate structure 130'.

The second gate bus line 165 may pass through the first insulating pattern ILD1 in the 1-1 portion 165_1 to be connected to the 1-1 gate bus line 155a'. The second gate bus line 165 may pass through the first insulating pattern ILD1 in the 1-2 portion 165_5 to be connected to the 1-2 gate bus line 155b'.

The second portion (165_2, 165_3, and 165_4) of the second gate bus line 165 may extend from the first portion (165_1 and 165_5), and may overlap the first source electrode 150' in the vertical direction (Z-direction). The second portion (165_2, 165_3, and 165_4) may overlap a portion of the finger portion 132 in the vertical direction (Z-direction).

A conductive terminal 170 may be disposed on the second portion 165_3 of the second gate bus line 165. In an example, the second portion 165_3 of the second gate bus line 165 may overlap the conductive terminal 170 in the vertical direction (Z-direction).

The second source electrode 160 may be disposed on the first insulating pattern ILD1 covering the first source electrode 150'. The second source electrode 160 may overlap the first source electrode 150' in the vertical direction (Z-direction). In an example, an area of the second source electrode 160 on a plane may be smaller than an area of the first source electrode 150' on a plane. The second source electrode 160 may overlap a portion of the finger portion 132 of the gate structure 130'. In an example, the second source electrode 160 may pass through the first insulating pattern ILD1 covering the first source electrode 150', to be connected to the first source electrode 150'.

A power semiconductor device 100a according to embodiments may include a first gate bus line 155' connected to a gate structure 130', and a second gate bus line 165 connected to the first gate bus line 155' and a conductive terminal 170 and overlapping a first source electrode 150' (or a cell region R3). Therefore, a power semiconductor device having improved electrical characteristics may be provided by securing the cell region R3.

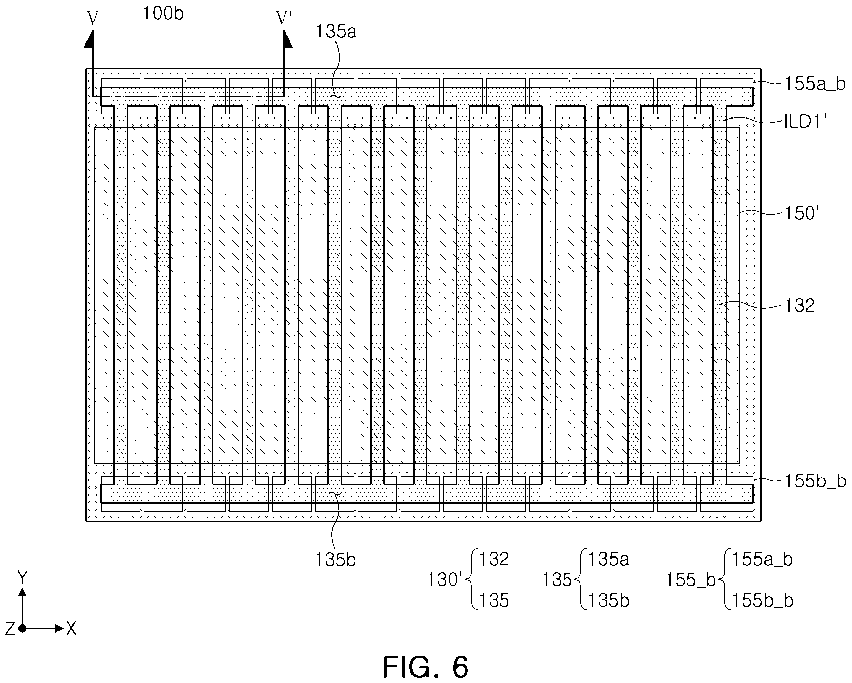

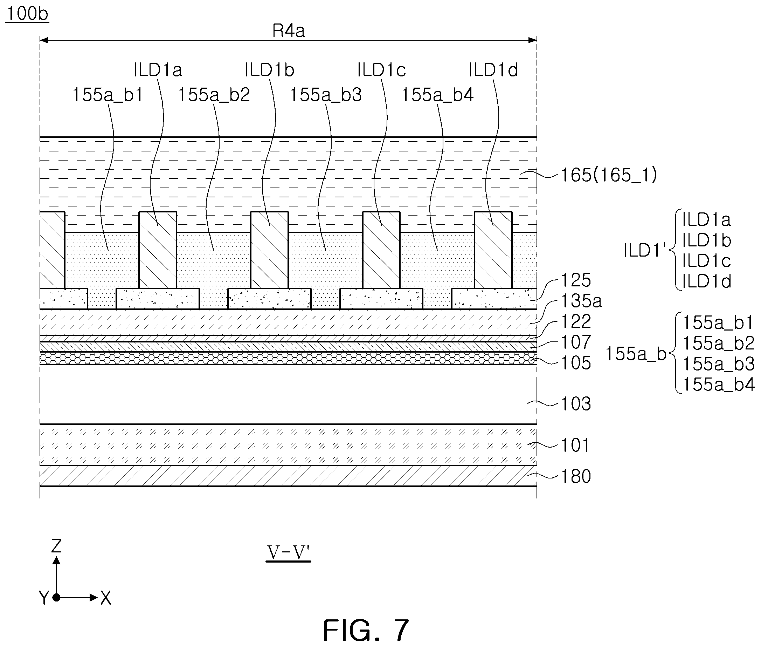

FIG. 6 is a schematic plan view of a component of a power semiconductor device according to one or more embodiments. FIG. 7 is a cross-sectional view illustrating one or more embodiments of the power semiconductor device of FIG. 6, taken along line V-V'.

FIG. 6 may be a schematic plan view of a gate structure 130', a first gate bus line 155_b, and a first source electrode 150' of a power semiconductor device 100b according to one or more embodiments.

Referring to FIGS. 6 and 7, a power semiconductor device 100b may be equal to or correspond to configurations illustrated in FIGS. 5A and 5B, except for a first gate bus line 155_b and a first insulating pattern ILD1'. Overlapping descriptions of components, equal to or corresponding to the configurations illustrated in FIGS. 5A and 5B, will be omitted.

Referring to FIGS. 6 and 7, the power semiconductor device 100b may include a substrate 101, a drift layer 103 on the substrate 101, well regions 105 extending from an upper surface of the drift layer 103, a source region 107 extending from an upper surface of a well region 105 in each of the well regions 105, a gate structure 130' on the drift layer 103, an insulating liner 122 between the gate structure 130' and the well region 105, dielectric layers 125 covering the gate structure 130', a first source electrode 150' and a first gate bus line 155_b covering the dielectric layers 125, a second source electrode 160 disposed on a portion of the first source electrode 150', a second gate bus line 165 disposed on the first gate bus line 155_b and extending onto the first source electrode 150', and a drain electrode 180 on a lower surface of the substrate 101. In an example, the power semiconductor device 100b may further include a first insulating pattern ILD1' disposed between the first source electrode 150' and the first gate bus line 155_b, and a second insulating pattern ILD2 disposed between the second source electrode 160 and the second gate bus line 165. The second gate bus line 165 and the second source electrode 160 of the power semiconductor device 100 of FIG. 1C may be applied to the power semiconductor device 100b.

The first gate bus line 155_b may include a 1-1 gate bus line pattern 155a_b overlapping a first body portion 135a, and a 1-2 gate bus line pattern 155b_b overlapping a second body portion 135b. In an example, the 1-1 gate bus line pattern 155a_b and the 1-2 gate bus line pattern 155b_b may be spaced apart from each other in the second direction (Y-direction). The 1-1 gate bus line pattern 155a_b and the 1-2 gate bus line pattern 155b_b may include electrode patterns spaced apart in the first direction (X-direction), respectively. In an example, the 1-1 gate bus line pattern 155a_b may include electrode patterns 155a_b1, 155a_b2, 155a_b3, and 155a_b4 spaced apart in the first direction (X-direction). The 1-2 gate bus line pattern 155b_b may also include electrode patterns spaced apart in the first direction (X-direction), similar to the 1-1 gate bus line pattern 155a_b.

The electrode patterns included in each of the 1-1 gate bus line pattern 155a_b and the 1-2 gate bus line pattern 155b_b may be disposed spaced apart from each other in the first direction (X-direction) by the first insulating pattern ILD1'. A finger portion 132 may branch from the electrode patterns respectively included in the 1-1 gate bus line pattern 155a_b and the 1-2 gate bus line pattern 155b_b, and may extend in the second direction (Y-direction). In an example, the first insulating pattern ILD1' may be disposed between the electrode patterns 155a_b1, 155a_b2, 155a_b3, and 155a_b4 of the 1-1 gate bus line pattern 155a_b. For example, a 1-1 insulating pattern ILD1a may be disposed between a 1-1 electrode pattern 155a_b1 and a 1-2 electrode pattern 155a_b2, a 1-2 insulating pattern ILD1b may be disposed between the 1-2 electrode pattern 155a_b2 and a 1-3 electrode pattern 155a_b3, and a 1-3 insulating pattern ILD1c may be disposed between the 1-3 electrode pattern 155a_b3 and a 1-4 electrode pattern 155a_b4. The 1-4 electrode pattern 155a_b4 may be disposed between the 1-3 insulating pattern ILD1c and a 1-4 insulating pattern ILD1d.

The first insulating pattern ILD1' may expose an upper surface of an electrode pattern of the 1-1 gate bus line pattern 155a_b and an upper surface of an electrode pattern of the 1-2 gate bus line pattern 155b_b. In an example, upper portion surfaces of the electrode patterns 155a_b1, 155a_b2, 155a_b3, and 155a_b4 of the 1-1 gate bus line pattern 155a_b may be exposed by the first insulating pattern ILD1'.

The second gate bus line 165 may be in contact with an upper portion surface of an electrode pattern of the 1-1 gate bus line pattern 155a_b and an upper portion surface of an electrode pattern of the 1-2 gate bus line pattern 155b_b, exposed by the first insulating pattern ILD1'. In an example, a 1-1 portion 165_1 of the second gate bus line 165 may be in contact with the upper portion surfaces of the electrode patterns 155a_b1, 155a_b2, 155a_b3, and 155a_b4 of the 1-1 gate bus line pattern 155a_b. A 1-2 portion 165_5 of the second gate bus line 165 may be in contact with the upper portion surface of the electrode patterns of the 1-2 gate bus line pattern 155b_b.

The electrode patterns 155a_b1, 155a_b2, 155a_b3, and 155a_b4 of the 1-1 gate bus line pattern 155a_b may pass through the dielectric layer 125 covering the first body portion 135a of the gate structure 130', to be connected to the gate structure 130'.

In one or more embodiments, the 1-1 extension portion 155a_1 and the 1-2 extension portion 155b_1 of the first gate bus line 155 of the power semiconductor device 100 of FIG. 1B may also include electrode patterns spaced apart in the first direction (X-direction), respectively.

A phenomenon of a relatively large voltage drop occurring in a region far from a gate pad (e.g., conductive terminal 170 of FIG. 5B) in a power semiconductor device 100b may be improved to enhance uniformity of a voltage drop. For example, uniformity of a voltage applied to gate structure 130' through a conductive terminal 170 in a power semiconductor device 100b may be improved.

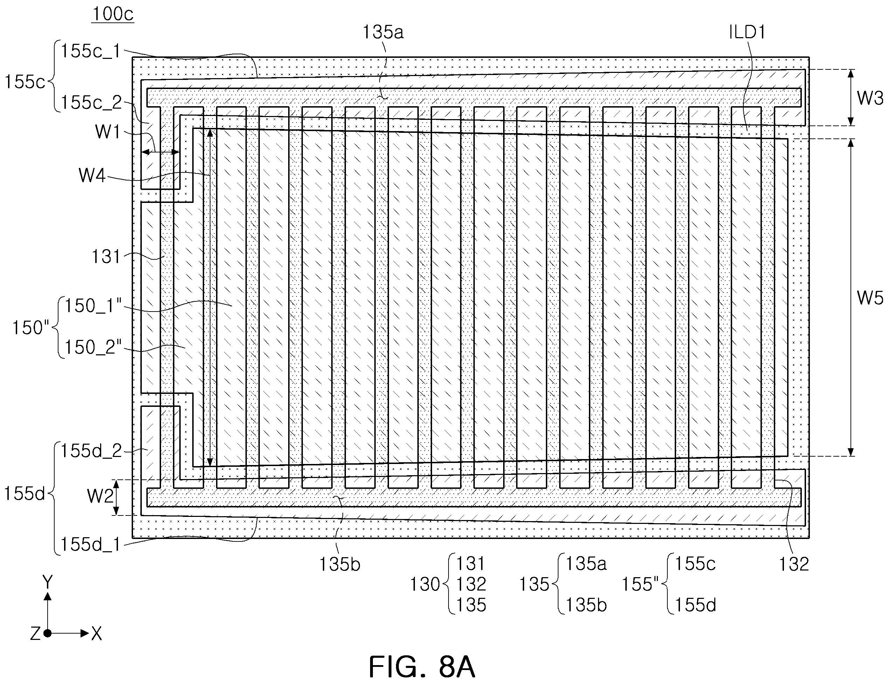

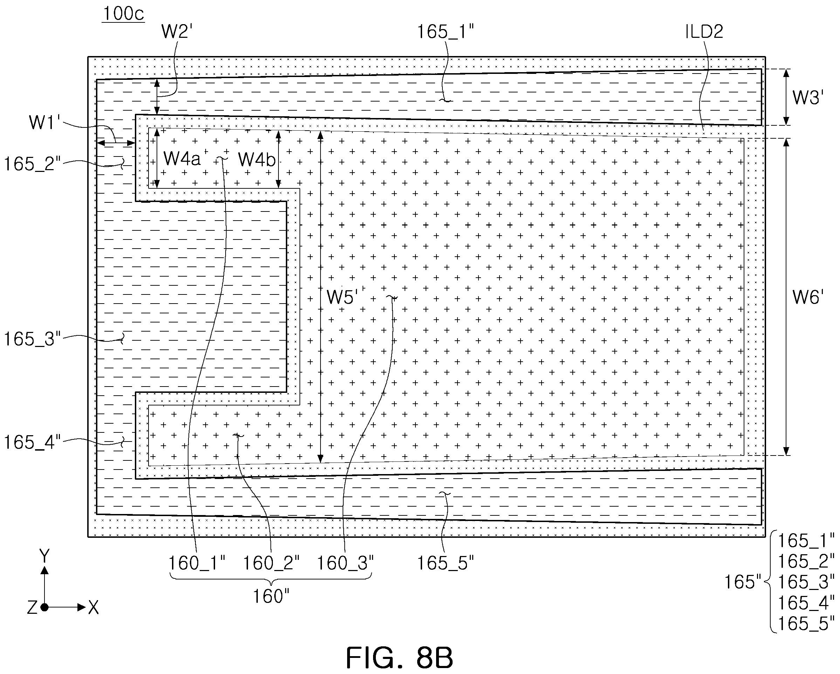

FIGS. 8A and 8B are schematic plan views of some components of a power semiconductor device according to one or more embodiments.

FIG. 8A may be a schematic plan view of a gate structure 130, a first gate bus line 155", and a first source electrode 150" of a power semiconductor device 100c according to one or more embodiments. FIG. 8B may be a schematic plan view of a second gate bus line 165" and a second source electrode 160" of a power semiconductor device 100c according to one or more embodiments.

Referring to FIGS. 8A and 8B, a power semiconductor device 100c may be equal to or correspond to configurations illustrated in FIGS. 2A and 2B, except for a first gate bus line 155", a first source electrode 150", a second gate bus line 165", and a second source electrode 160". Overlapping descriptions of components, equal to or corresponding to the configurations illustrated in FIGS. 2A and 2B, will be omitted.

The first gate bus line 155" and the second gate bus line 165" of the power semiconductor device 100c according to one or more embodiments may have a cross-sectional area that is gradually changing in the first direction (X-direction), which is an extension direction.

The first gate bus line 155" may include a 1-1 gate bus line 155c and a 1-2 gate bus line 155d spaced apart from the 1-1 gate bus line 155c in the second direction (Y-direction). In an example, the 1-1 gate bus line 155c may include a 1-1 extension portion 155c_1 overlapping a first body portion 135a of the gate structure 130 and extending in the first direction (X-direction), and a 1-1 bent portion 155c_2 extending from the 1-1 extension portion 155c_1 and disposed on one end of a first finger portion 131. The 1-2 gate bus line 155d may include a 1-2 extension portion 155d_1 overlapping a second body portion 135b of the gate structure 130 and extending in the first direction (X-direction), and a 1-2 bent portion 155d_2 extending from the 1-2 extension portion 155d_1 and disposed on the other end of the first finger portion 131.

The 1-1 extension portion 155c_1 of the 1-1 gate bus line 155c and the 1-2 extension portion 155d_1 of the 1-2 gate bus line 155d may have an increased cross-sectional area as an electrical path from a gate pad (e.g., conductive terminal 170 of FIG. 2B) increases. Unless otherwise described herein, the 'cross-sectional area' means an area of a cross-section, perpendicular to an extension direction. The 1-1 extension portion 155c_1 and the 1-2 extension portion 155d_1 may have an increasing cross-sectional area, respectively, as it gets farther away from a conductive terminal 170, and for example, a width thereof may increase. A width of the 1-1 extension portion 155c_1 and a width of the 1-2 extension portion 155d_1 may gradually increase in the first direction (X-direction), which is an extension direction. The width of the 1-1 extension portion 155c_1 and the width of the 1-2 extension portion 155d_1 may increase continuously and linearly, but is not limited thereto, and the width of the 1-1 extension portion 155c_1 and the width of the 1-2 extension portion 155d_1 may increase discontinuously or non-linearly.

The width of each of the 1-1 extension portion 155c_1 and the 1-2 extension portion 155d_1 may gradually increase a second width W2 in the second direction (Y-direction) to a third width W3 in the second direction (Y-direction).

The 1-1 bent portion 155c_2 of the 1-1 gate bus line 155c and the 1-2 bent portion 155d_2 of the 1-2 gate bus line 155d may have a constant cross-sectional area, respectively, in the second direction (Y-direction). For example, the 1-1 bent portion 155c_2 and the 1-2 bent portion 155d_2 may have a constant first width W1, respectively, in the second direction (Y-direction), but is not limited thereto, and the 1-1 bent portion 155c_2 and the 1-2 bent portion 155d_2 may have an increasing cross-sectional area, respectively, as it gets farther away from the conductive terminal 170 in the second direction (Y-direction). For example, the 1-1 bent portion 155c_2 and the 1-2 bent portion 155d_2 may have a width, respectively, smaller than a width of a portion spaced a first distance from the conductive terminal 170 by a second distance, greater than the first distance.

The first source electrode 150" may be disposed on a portion of the gate structure 130. In an example, the first source electrode 150" may be disposed on a portion of the first finger portion 131 and a second finger portion 132. The first source electrode 150" may include a 1-1 source electrode 150_1" disposed on the second finger portion 132, and a 1-2 source electrode 150_2" extending from the 1-1 source electrode 150_1" and disposed on a portion of the first finger portion 131.

A width of the 1-1 source electrode 150_1" may gradually decrease in the first direction (X-direction), which is an extension direction. The 1-1 source electrode 150_1" may have a fourth width W4 in a portion spaced a first distance from the conductive terminal 170, and may have a fifth width W5, smaller than the fourth width W4, in a portion spaced a second distance, greater than the first distance.

The width of the 1-1 source electrode 150_1" may decrease continuously, and may decrease linearly, but is not limited thereto, and the width of the 1-1 source electrode 150_1" may decrease discontinuously or non-linearly. In an example, as the width of the 1-1 extension portion 155c_1 and the width of the 1-2 extension portion 155d_1 increase in the first direction (X-direction), which is an extension direction, the width of the 1-1 source electrode 150_1" may decrease in the first direction (X-direction).

The second source electrode 160" and the second gate bus line 165" may be disposed on the first source electrode 150" and the first gate bus line 155".

The second gate bus line 165" may include a first portion (165_1", 165_2", 165_4", and 165_5") overlapping the first gate bus line 155", and a second portion 165_3" extending from the first portion (165_1", 165_2", 165_4", and 165_5") to connect the first portion (165_1", 165_2", 165_4", and 165_5").

A shape of the first portion (165_1", 165_2", 165_4", 165_5") of the second gate bus line 165" may correspond to a shape of the first gate bus line 155". A 1-1 portion (165_1" and 165_2") may overlap the 1-1 gate bus line 155c. A 1-2 portion (165_4" and 165_5") may overlap the 1-2 gate bus line 155d.

The 1-1 portion 165_1" and the 1-2 portion 165_5" overlapping the 1-1 extension portion 155c_1 and the 1-2 extension portion 155d_1 of the first gate bus line 155" may have an increasing cross-sectional area, respectively, as they get far away from the conductive terminal 170, for example, an increasing width. In an example, the width of each of the 1-1 portion 165_1" and the 1-2 portion 165_5" may gradually increase from a second width W2' in the second direction (Y-direction) to a third width W3' as a maximum width in the second direction (Y-direction).

The 1-1 portion 165_2" and the 1-2 portion 165_4" overlapping the 1-1 bent portion 155c_2 and the 1-2 bent portion 155d_2 of the first gate bus line 155" may have a constant cross-sectional area, respectively, in the second direction (Y-direction). For example, the 1-1 portion 165_2" and the 1-2 portion 165_4" may have a constant first width W1', respectively, in the second direction (Y-direction), but is not limited thereto, and the 1-2 portion 165_2" and the 1-2 portion 165_4" may have an increasing cross-sectional area, respectively, as they get far away from the conductive terminal 170 in the second direction (Y-direction).

The second portion 165_3" of the second gate bus line 165" may extend from the first portion (165_1", 165_2", 165_4", and 165_5") and overlap the first source electrode 150".

The second source electrode 160" may be disposed on a first insulating pattern ILD1 covering the first source electrode 150". The second source electrode 160" may overlap the first source electrode 150" in the third direction (Z-direction).

The second source electrode 160" may include a 2-1 source electrode 160_3", and 2-2 source electrodes 160_1" and 160_2" extending from the 2-1 source electrode 160_3" and disposed between the first portion (165_1" and 165_5") and the second portion 165_3" of the second gate bus line 165". The 2-2 source electrodes 160_1" and 160_2" may include a 2-2a source electrode 160_1" located between the first portion 165_1" and the second portion 165_3", and a 2-2b source electrode 160_2" located between the first portion 165_5" and the second portion 165_3". In an example, the 2-2a source electrode 160_1" and the 2-2b source electrode 160_2" may be spaced apart in a second direction (Y-direction), with the second portion 165_3" of the second gate bus line 165" interposed therebetween.

A cross-sectional area of the 2-2a source electrode 160_1" and a cross-sectional area of the 2-2b source electrode 160_2" may decrease, as they get far away from the conductive terminal 170. The width of each of the 2-2a source electrode 160 1" and the 2-2b source electrode 160_2" may gradually decrease from a 4-1 width W4a to a 4-2 width W4b.

The 2-1 source electrode 160_3" may have a shape corresponding to a shape of the 1-1 source electrode 150_1", overlapping the same. In an example, a width of the 2-1 source electrode 160_3" may gradually decrease in the first direction (X-direction) which is an extension direction. The 2-1 source electrode 160_3" may have a fifth width W5' in a portion spaced a first distance from the conductive terminal 170, and may have a sixth width W6', smaller than the fifth width W5', in a portion spaced a second distance, greater than the first distance.

A power semiconductor device 100c according to one or more embodiments may include first and second gate bus lines 155" and 165" having a wider width, as a distance from a conductive terminal 170 increases. For example, one region of the first and second gate bus lines 155" and 165", relatively adjacent to the conductive terminal 170, may have relatively high resistance, and the other region of the first and second gate bus lines 155" and 165", relatively far away from the conductive terminal 170, may have relatively low resistance. Therefore, a phenomenon of a large voltage drop occurring in a region relatively distant from the conductive terminal 170 in the power semiconductor device 100c may be improved, and uniformity of voltage drop may be improved.

Embodiments of the present disclosure may include a first gate bus line connected to the gate structure, and a second gate bus line overlapping a cell region and connected to the first gate bus line and a conductive terminal to which an external voltage is applied, to secure the cell region and to provide a power semiconductor device having improved electrical characteristics.

Effects of the present disclosure are not limited to the effects described above, and may be variously expanded without departing from the spirit and scope of the present disclosure.

While example embodiments have been illustrated and described above, it will be apparent to those skilled in the art that modifications and variations could be made without departing from the scope of the present disclosure as defined by the appended claims.

## Claims

1. A power semiconductor device comprising:
a substrate of a first conductivity-type;
a drift layer of the first conductivity-type on the substrate;
a well region of a second conductivity-type in the drift layer and extending to an upper surface of the drift layer;
a source region of the first conductivity-type in the well region and extending to an upper surface of the well region;
an insulating liner on the drift layer;
a gate structure on the insulating liner;
a first gate bus line on the gate structure;
a second gate bus line on the first gate bus line, the second gate bus line comprising:
a first portion overlapping the first gate bus line in a direction perpendicular to an upper surface of the substrate; and
a second portion connected to the first portion and not overlapping the first gate bus line in the direction perpendicular to the upper surface of the substrate;
a terminal on the second portion of the second gate bus line; and
a drain electrode on a lower surface of the substrate.

2. The power semiconductor device of claim 1, wherein the terminal does not overlap the first gate bus line in the direction perpendicular to the upper surface of the substrate.

3. The power semiconductor device of claim 1 or claim 2, further comprising:
a dielectric layer covering the gate structure; and
a first source electrode on the dielectric layer and contacting the source region,
wherein the second portion of the second gate bus line overlaps the first source electrode in the direction perpendicular to the upper surface of the substrate.

4. The power semiconductor device of claim 3, further comprising:
an upper portion surface of the first gate bus line and an upper portion surface of the first source electrode that are at a same level.

5. The power semiconductor device of claim 3 or claim 4, further comprising:
a first insulating pattern between the first gate bus line and the first source electrode.

6. The power semiconductor device of any of claims 3-5, further comprising:
a second source electrode on the first source electrode and connected to the first source electrode.

7. The power semiconductor device of claim 6, wherein an upper portion surface of the second gate bus line and an upper portion surface of the second source electrode are at a same level.

8. The power semiconductor device of claim 6 or claim 7, further comprising:
a second insulating pattern between the second gate bus line and the second source electrode.

9. The power semiconductor device of any preceding claim,
wherein the gate structure comprises a first body portion, a second body portion, and a finger portion connecting the first body portion and the second body portion, the first body portion and the second body portion being spaced apart and extending in a first direction, and
wherein the first gate bus line and the first portion of the second gate bus line overlap the first body portion and the second body portion, and the second portion of the second gate bus line overlaps the finger portion in the direction perpendicular to the upper surface of the substrate.

10. The power semiconductor device of claim 9,
wherein the first gate bus line comprises a third portion overlapping the first body portion and the second body portion in the direction perpendicular to the upper surface of the substrate and extending in the first direction, and a fourth portion extending from the third portion in a second direction intersecting the first direction, and
wherein the fourth portion of the first gate bus line overlaps a portion of a first gate electrode of the finger portion in the direction perpendicular to the upper surface of the substrate.

11. The power semiconductor device of claim 10, wherein the second portion of the second gate bus line overlaps a remaining portion of the first gate electrode of the finger portion in the direction perpendicular to the upper surface of the substrate.

12. The power semiconductor device of any of claims 9-11, wherein the first gate bus line has a bar shape extending in the first direction.

13. The power semiconductor device of any of claims 9-11, wherein the first gate bus line comprises electrode patterns spaced apart from each other in the first direction and connected to the second gate bus line, the power semiconductor device further comprising:
first insulating patterns between the electrode patterns.

14. The power semiconductor device of any of claims 9-13, wherein the terminal overlaps the finger portion of the gate structure in the direction perpendicular to the upper surface of the substrate.

15. The power semiconductor device of any of claims 9-14, wherein the second gate bus line is in contact with the first gate bus line on the first body portion and the second body portion or the finger portion.
